# EUROPEAN PATENT SPECIFICATION

(11) **EP 4 189 749 B1**
(45) Date of publication and mention of the grant of the patent: **04.09.2024**
(21) Application number: 21749791.6
(22) Date of filing: 22.07.2021
(51) Int. Cl.: H01L 31/078, H10K 30/57, H10K 85/50

(54) **TWO TERMINAL PEROVSKITE / SILICON TANDEM SOLAR CELL AND ASSOCIATED MANUFACTURING METHOD**
PEROWSKIT-SILICIUM-TANDEMSOLARZELLE MIT ZWEI ANSCHLÜSSEN UND ZUGEHÖRIGES HERSTELLUNGSVERFAHREN
CELLULE SOLAIRE TANDEM PÉROVSKITE/SILICIUM À DEUX BORNES ET PROCÉDÉ DE FABRICATION ASSOCIÉ

(30) Priority: 31.07.2020 EP 20315373
(43) Date of publication of application: 07.06.2023
(73) Proprietor: TOTALENERGIES ONETECH, 92400 Courbevoie (FR); Electricité de France, 75008 Paris (FR); L'AIR LIQUIDE, SOCIETE ANONYME POUR L'ETUDE ET L'EXPLOITATION DES PROCEDES GEORGES CLAUDE, 75007 Paris (FR); Centre National de la Recherche Scientifique, 75016 Paris (FR); Ecole Polytechnique, 91120 Palaiseau (FR); Institut Photovoltaique d'Ile de France, 91120 Palaiseau (FR)
(72) Inventor: SCHULZ, Philip, 94260 Fresnes (FR); HUANG, Yong, Guilin, 541002 (CN)
(74) Representative: Innovincia
(86) International application number: PCT/EP2021/070608
(87) International publication number: WO 2022/023182

(56) References cited:
- US-A1- 2016 307 704
- US-B2- 10 622 409
- GEDE W. P. ADHYAKSA ET AL: "Nanoscale Back Contact Perovskite Solar Cell Design for Improved Tandem Efficiency", NANO LETTERS, vol. 17, no. 9, 16 August 2017 (2017-08-16), US, pages 5206 - 5212, XP055592769, ISSN: 1530-6984, DOI: 10.1021/acs.nanolett.7b01092
- TRAHMS MARTINA ET AL: "All-Thin-Film Tandem Cells Based on Liquid Phase Crystallized Silicon and Perovskites", IEEE JOURNAL OF PHOTOVOLTAICS, I E E E, US, vol. 9, no. 3, 1 May 2019 (2019-05-01), pages 621 - 628, XP011720901, ISSN: 2156-3381, [retrieved on 20190419], DOI: 10.1109/JPHOTOV.2019.2896995

## Description

### Background of the invention

The present invention refers to photovoltaic energy production and in particular high efficiency photovoltaic cells, or solar cells, enabling the conversion of the solar energy into electricity.

With climate change, global warming and the fossil fuel depletion, many technologies have been developed over the past few years in order to use alternate resources and in particular renewable energy resources.

A solar cell comprises a P-N junction wherein light is absorbed to create electron-hole pairs and opposite electrodes to collect electrons on one side and holes on the other side.

In order to improve the efficiency of the photovoltaic cells, one way is to stack two photovoltaic cells having different bandgaps to form a tandem photovoltaic cell wherein each photovoltaic cell will convert a different part of the solar spectrum of the incoming light.

The tandem photovoltaic cells usually comprise a back photovoltaic cell based on silicon and having a bandgap around 1.1 eV.

The front photovoltaic cell needs to have a higher bandgap, preferably around 1.7 eV. Perovskite based solar cells enable to achieve such bandgap with a limited cost and are therefore promising candidates for highly efficient tandem solar cells.

However, perovskite absorber materials have also drawbacks, in particular their limited stability with respect to H₂O and O₂. Indeed, perovskite may be degraded by the presence of O₂ and H₂O in its environment so that perovskite needs to be protected from such degradation. One way to protect perovskite is to add encapsulation layers over the perovskite. The encapsulation layers refer notably to a layer of indium tin oxide (ITO) arranged on the top of the perovskite layer and providing a transparent carrier transport layer. However, to obtain a good lateral conductivity, the ITO layer requires a high temperature process, for example higher than 200°C leading to a degradation of the perovskite. Furthermore, the transparent conductive oxides (TCO) such as ITO arranged above the perovskite layer lead to parasitic absorption in the near infra-red spectrum and therefore limit the efficiency and tend to be expensive.

It is therefore necessary to find a solution enabling the production of a perovskite based tandem cell wherein the perovskite is protected by passivation layers without requiring high temperature process, notably process requiring a temperature higher than 110°C in order to avoid the perovskite degradation during the manufacturing process. Documents US 2016/307704 A1 and US 10622409 B2 disclose tandem solar cells of the state of the art.

The present invention aims therefore at providing a solution to obtain a tandem photovoltaic cell based on silicon and perovskite sub-cells with good resistance against oxidation contaminants and high power conversion efficiency.

### Summary of the invention

The present invention refers to a two terminal tandem cell comprising:
- a silicon bottom cell comprising a silicon layer, a rear contact configured to be linked to a first terminal and a front contact,
- a perovskite top cell comprising a layer of perovskite and a capping layer,
wherein the perovskite top cell comprises alternated back contacts made by a first carrier transport layer arranged on the front contact of the silicon bottom cell to produce a recombination layer or tunnel junction interface and a second carrier transport layer configured to be linked to a second terminal and wherein an insulator layer is arranged on one side between the silicon bottom cell and the second carrier transport layer and on the other side between the first carrier transport layer and the second transport layer.

The first and the second carrier transport layers may have opposite doping type and the combination of the first carrier transport layer, the insulator layer and the second carrier transport layer may produce a P-I-N junction (or a series of P-I-N junctions). Besides, by opposite doping type it is herein meant that one layer has a N-type doping and the other layer has a P-type doping. The second carrier transport layer may be linked to the second terminal via lateral metallic contacts.

The two terminal tandem cell may present one or several of the following aspects taken alone or in combination.

According to another aspect of the present invention, the electrical conductivity, the thickness and the pitch of the second carrier transport layer are configured to ensure lateral carrier transport toward the second terminal.

According to a further aspect of the present invention, the second carrier transport layer comprises at least one sub-layer made of metal or transparent conducting oxide to enhance lateral carrier transport toward the second terminal.

According to another aspect of the present invention, the first carrier transport layer and the second carrier transport layer have opposite doping type. One is n-doped whereas the other one is p-doped

According to a further aspect of the present invention, the thickness of the first carrier transport layer, the second carrier transport layer and the insulator layer is comprised between 2nm and 1µm, preferably between 10nm and 100nm.

According to another aspect of the present invention, the thickness of the perovskite layer is comprised between 100nm to 2µm.

In this invention the term "perovskite" refers to a material which may be represented by the formula 'A"B''X'3, wherein 'A' is at least one cation, 'B' is at least one cation, and 'X' is at least one anion. The cation 'A' can be organic, inorganic, or an organic-inorganic cation. When the cation 'A' is organic, the organic cation can have the formula (R1R2R3R4N)n+ or (R5R6N=CH-NR7R8)n+, where R is hydrogen, unsubstituted or substituted alkyl, or unsubstituted or substituted aryl, and n is equal or superior to one (e.g. 'CH3NH3'+ refers as MA, 'HC(NH2)2'+ refers as FA, 'C(NH2)3'+ refers as GA). When the cation 'A' is inorganic, the cation can be selected from the group consisting of Ag+, Li+, Na+, K+, Rb+, Cs+, Be2+, Mg2+, Ca2+, Pb2+, Sr2+, Ba2+, Fe2+, Sc3+, Y3+, and La3+. The cation can be used as a single or multiple ion (e.g. (Mg,Fe)SiO3), YBaCuO3).

When the cation 'A' is organic-inorganic, the cation can be used as a single or multiple ion such as 'A'=(M1n(R21-xR3x) (100-n)), where R is preferably an organic cation as described above and M is preferably an inorganic cation comprised as described above (e.g. FA1-xGax`B"X'3, Csx(MAnFA1-n) (100-x) 'B''X'3).

The cation 'B' can be a metal cation selected from the group consisting of Pb2+, Sn2+, Ge2+, Bi2+, Cu2+, Au2+, Ag2+, Sb2+, Nb2+, Ti2+, Mg2+, Si2+, Ca2+, Sr2+, Cd2+, Ni2+, Mn2+, Fe2+, Zr4+, Co2+, Pd2+, Yb2+, Eu2+, Ce4+, and Tb4+. The anion 'X' can be selected from the group consisting of halide anions comprising Cl-, Br-, I-, F-, or chalcogenide anions comprising O2-, S2-, Se2-, Te2-, or polyanions comprising BF4-, PF6-, SCN-. The anion can be used as a single or multiple ions such as 'X'=(R1-xRx), where R is an anion as listed above. The invention also includes other type of perovskites that can be elaborated: Cuprate perovskite (La2-xBaxCuO4, YBa2Cu3O7, Ba2MCu3O7, where M is a rare earth ion such as Pr, Y, Nd, Sm, Gd, Dy, Ho). Metal perovskite can be produced based on a RT3M structure, where R is a rare-earth ion, T is a transition metal ion (Pd, Rh, Ru) and M is a light metalloid (e.g. B, C).

The definition above on the range of materials thus includes, but is not limited to, the following compounds: CH3NH3PbX3, Csx(CH3(NH2)2)1-xPbX3, Csx((CH3NH3)y(CH3(NH2)2)1-y)(1-x)PbX3, AxCsy((CH3NH3)z(CH3(NH2)2)1-z)1-yPbX3 where A is an alkali metal (Li, Na, K, Rb), BaTiO3, PbTiO3, CaTiO3, SrTiO3, PbZrO3, SrTiO3, KTaO3, KNbO3, NaNbO3, Pb(Mg1/3Nb2/3)O3, Pb(Zn1/3Nb2/3)O3, Pb(Mn1/3Sb2/3)O3, Pb(Co1/3Nb2/3)O3, Pb(Mn1/3Nb2/3)O3, Pb(Ni1/3Nb2/3)O3, Pb(Sb1/2Sn1/2)O3, Pb(Co1/2W1/2)O3, Pb(Mg1/2W1/2)O3, LiNbO3, LiTaO3, BiTiO3, NaTiO3, NaNbO3, KNbO3, La1-xSrxMnO3, La2NiO4, La2CoO4, GdBaCo2O5, PrBaCo2O5, NdBa1-xSrxCoO2O5, Ba1-xSrxCo1-yFeyO3, BiCr1-xGaxO3, NaNbO3, KNbO3, LaFeO3, LaCoxFe1-xO3, La1-xSrxCoO3, LaSrNiO4, LaxSrx-1FeyBiy-1O3, La2NiO4, La2-xSrxCuO4, LaSrNi1-xAlxO4, LaMnO3, LaFeO3, LaCoO3, LaTi1xCuxO3, LiTaO3, NaTaO3, KTaO3, CaTa2O6, SrTa2O6, BaTa2O6, (La1-xSrxCoO3, Pr1-xSrxCoO3, Sm1-xSrxCoO3, Gd1-xSrxCoO3, Tb1-xSrxCoO3, LaCoO3, La1-xSrxMnO3, LaCo1-xNixO3)

According to a further aspect of the present invention, the capping layer of the perovskite top cell is deposited at a temperature lower than 160°C, preferentially below 110°C, to avoid damages to the perovskite material.

According to another aspect of the present invention, the capping layer is configured to prevent recombination of free carriers, and is for example made of polymethylmetacrylat "PMMA", Al₂O₃, SiO₂ or Phenyl-C61-butyric acid methyl ester "PCBM". The capping layer may be used as a passivation layer for the perovskite layer.

According to a further aspect of the present invention, the front contact of the silicon bottom cell is achieved by one of the following solutions:
- a heterojunction of amorphous silicon,
- diffusion doped layers,
- passivating contacts notably polysilicon.

According to another aspect of the present invention, the silicon layer of the silicon bottom cell is made of N-type doped silicon, the front contact of the silicon bottom cell is made of P-type doped silicon and the first carrier transport layer is made of tin oxide "SnOₓ".

According to a further aspect of the present invention, the second carrier transport layer comprises a layer of silver doped nickel oxide "Ag:NiO".

According to another aspect of the present invention, the silicon layer of the silicon bottom cell is made of P-type doped silicon, the front contact of the silicon bottom cell is made of N-type doped silicon and the first carrier transport layer is made of nickel oxide "NiOₓ".

According to a further aspect of the present invention, the second carrier transport layer comprises a layer of tin oxide "SnOₓ".

According to another aspect of the present invention, the second carrier transport layer comprises a high electrical conductivity, for example by a free carrier concentration of at least 1E²⁰ at a carrier mobility of 10 cm²/Vs, and the pitch is lower than 5mm, for example lower than 3mm.

According to a further aspect of the present invention, the insulator layer is made of Hafnium dioxide "HfO_{2"} or aluminum oxide Al₂O₃.

The present invention also refers to a method for manufacturing a two terminal tandem cell comprising a silicon bottom cell and a perovskite top cell wherein the method comprises the following steps:
- providing a silicon bottom cell comprising a rear contact configured to be linked to a first terminal and a front contact, the silicon bottom cell corresponding to a first intermediate structure,
- depositing a first carrier transport layer over the front contact of the first intermediate structure to produce a second intermediate structure,
- etching selectively the first carrier transport layer and the front contact of the second intermediate structure to produce a third intermediate structure,
- depositing an insulator layer and a second carrier transport layer configured to be linked to a second terminal over the third intermediate structure to produce a fourth intermediate structure,
- etching the fourth intermediate structure to remove the layers covering the first carrier transport layer to produce a fifth intermediate structure,
- depositing a perovskite layer over the fifth intermediate structure to produce a sixth intermediate structure,
- depositing a capping layer over the sixth intermediate structure at a temperature lower than 110°C.

The silicon bottom cell may be a manufactured silicon cell of the market.

According to a further aspect of the present invention, the deposition steps are made by sputter deposition or atomic layer deposition "ALD" or plasma-enhanced chemical vapor deposition "PECVD" or similar physical and chemical vapor phase deposition techniques and the etching steps are made by chemical or physical etching. The perovskite deposition may be made by any combination of wet and vacuum based deposition processes.

### Brief description of the drawings

[Fig. 1] is a diagram of the different layers of a photovoltaic cell according to a general embodiment of the invention;
[Fig.2] is a diagram of the different layers of a photovoltaic cell according to a particular embodiment of the invention;
[Fig.3A] is a perspective view of a photovoltaic tandem cell according to the present invention;
[Fig.3B] is a sectional view of one photovoltaic tandem cell element of fig.3A according to a A-A cut line;
[Fig.3C] is a sectional view of one photovoltaic tandem cell element of fig.3A according to a B-B cut line;
[Fig.3D] is a sectional view of one photovoltaic tandem cell element of fig.3A according to a C-C cut line;
[Fig.3E] is a sectional view of one photovoltaic tandem cell element of fig.3A according to a D-D cut line;
[Fig.3F] is a sectional view of one photovoltaic tandem cell element of fig.3A according to a E-E cut line;
[Fig.4A] is a diagram of the efficiency and the open circuit voltage as a function of the free carrier concentration in the second carrier transport layer;
[Fig.4B] is a diagram of the fill factor and the short circuit current density as a function of the free carrier concentration in the second carrier transport layer;
[Fig.4C] is a diagram of the absorber photocurrent density and the residual photocurrent density in the second carrier transport layer as a function of the free carrier concentration in the second carrier transport layer;
[Fig.5] is a flowchart of different manufacturing steps of a tandem photovoltaic cell according to the invention;
[Fig.6] is a diagram of a first intermediate structure during the manufacturing process of a tandem photovoltaic cell according to the invention;
[Fig.7] is a diagram of a second intermediate structure during the manufacturing process of a tandem photovoltaic cell according to the invention;
[Fig.8] is a diagram of a third intermediate structure during the manufacturing process of a tandem photovoltaic cell according to the invention;
[Fig.9] is a diagram of a fourth intermediate structure during the manufacturing process of a tandem photovoltaic cell according to the invention;
[Fig. 10] is a diagram of a fifth intermediate structure during the manufacturing process of a tandem photovoltaic cell according to the invention;
[Fig. 11] is a diagram of a sixth intermediate structure during the manufacturing process of a tandem photovoltaic cell according to the invention.

### Detailed description of the invention

The following achievements are examples. Although, the specification refers to one or several embodiments, it does not imply that each reference refers to the same embodiment or that the features apply only to a single embodiment. Simple features of different embodiments can also be combined to provide other embodiments.

The present invention refers to a two terminal "2T" tandem photovoltaic cell comprising a silicon based bottom cell and a perovskite based top cell wherein the perovskite top cell comprises alternated back contacts and a capping layer configured as a passivation (and/or encapsulation) layer for the perovskite layer.

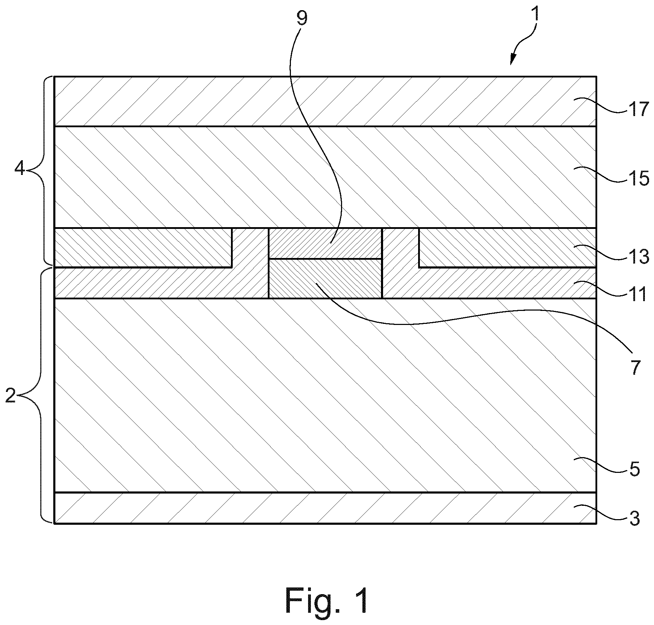

Fig.1 represents a diagram of the stack of the different layers of such tandem photovoltaic cell 1.

The tandem photovoltaic cell 1 comprises a rear contact layer 3, a silicon layer 5 and a localized front contact layer 7. By localized front contact layer 7, we herein mean that the front contact layer 7 does not cover all the surface of the silicon layer 5 but is localized for example in the shape of stripes extending across the silicon layer 5. These layers (3, 5 and 7) correspond to the silicon bottom cell 2. A first carrier transport layer 9 is arranged over the front contact layer 7 to produce a recombination layer or a tunnel junction interface between the silicon bottom cell 2 and the perovskite top cell 4. An insulator layer 11 is arranged over the portions of silicon layer 5 without front contact 7. A second carrier transport layer 13 is arranged over the insulator layer 11 and is alternated with the portions of the first carrier transport layer 9. Two adjacent portions of first 9 and second 13 carrier transport layers are separated by an insulator layer 11. The tandem photovoltaic cell 1 comprises for example a first series of stripes corresponding to the first carrier transport layer 9 and a second series of stripes corresponding to the second carrier transport layer 13, the first and the second series being alternated and separated by stripes of insulator layer 11. A perovskite layer 15 is arranged over the first 9 and second 13 carrier transport layers and a capping layer 17 is arranged over the perovskite layer 15. The first 9 and second 13 carrier transport layers, the perovskite layer 15 and the capping layer 17 correspond to the perovskite top cell 4.

A first terminal is linked to the rear contact layer 3 and a second terminal is linked to the portions of the second carrier transport layer 15.

The front contact 7 may be made by diffusion doped layers or by heterojunction such as amorphous silicon "SiA" or by passivating contacts such as polysilicon.

As indicated previously, the front contact 7 and the first carrier transport layer 9 may form a recombination layer wherein for example the electrons from the perovskite layer 15 are recombined with holes of the silicon layer 5 to produce pairs of electron-hole. Alternatively, the front contact 7 and the first carrier transport layer 9 may form a tunnel junction enabling for example electrons from the perovskite layer 15 to be transmitted toward the silicon layer 5 to be collected at the first terminal.

Depending on the doping of the different layers, the electrons may come from the silicon bottom cell 2 and be recombined in the recombination layer (7 and 9) or be transmitted toward the perovskite layer 15 to be collected at the second terminal.

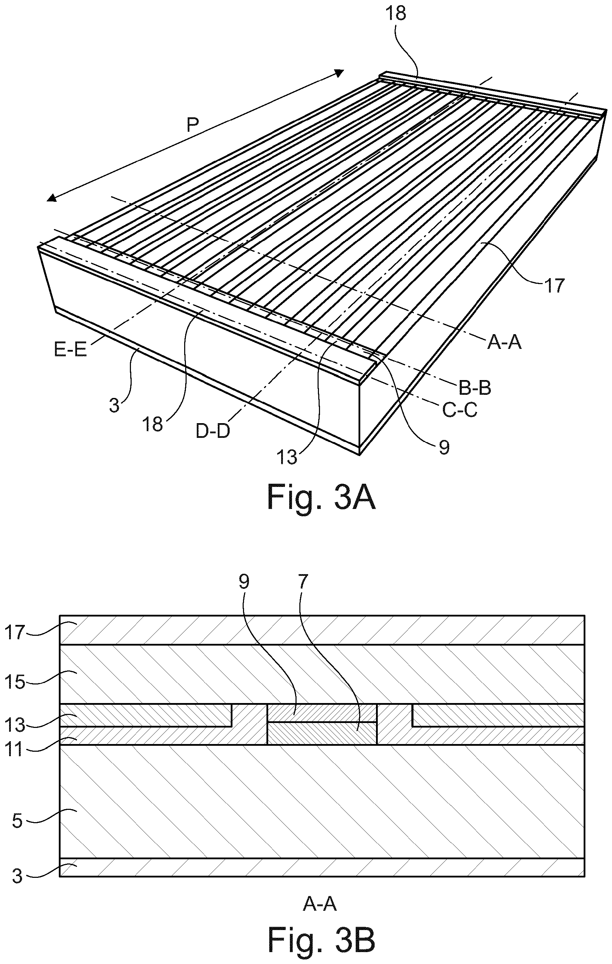

The first 9 and the second 15 carrier transport layers are configured to have opposite doping type. One has a N-type doping while the other has a P-type doping. Different material may be used for the first 9 and second 13 carrier transport layers such as TiO2, NiO, ZnO, MnO, CuSCN, SnO₂, CuO, CrO, SrO or VO...The first 9 and the second 13 carrier transport layers together with the insulator layer 11 form a horizontal P-I-N configuration of the perovskite top cell 4 as represented in Fig.3B.

The silicon based bottom cell 2 comprising the rear contact 3, the silicon layer 5 and the front contact 7 may be a silicon photovoltaic cell of the market (without anti-reflection layer) and the other layers may then be deposited (and possibly etched) over the provided silicon cell. Furthermore, concerning the capping layer 17, its deposition should be achieved at a temperature lower than 160°C, preferentially below 110°C, to avoid damaging the perovskite layer 15. Such low temperature may be achieved due to the fact that no collection of free carriers is achieved at the capping layer 17. The capping layer 17 may be configured to avoid recombination of electron-hole pairs in the capping layer 17.

The capping layer 17 may also be made from typical charge transport materials, such as Phenyl-C61-Butyric acid Methyl ester "PCBM".

Such structure enables therefore the deposition of the carrier transport layers 9 and 13 requiring a high temperature process, for example 200°C or more to be achieved before the deposition of the perovskite layer 15.

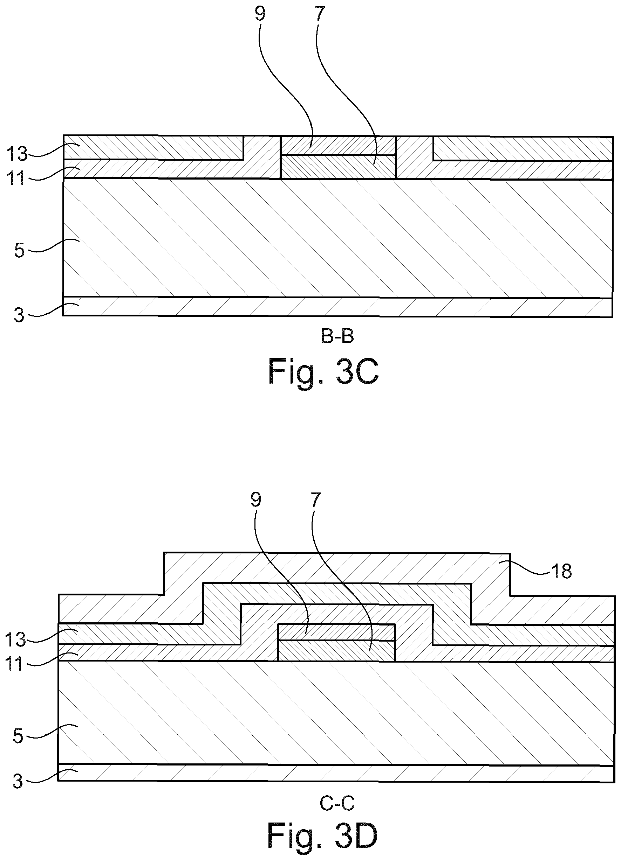

It has to be noted that Fig. 1 represents a basic pattern which may be replicated laterally to produce an alternation of portions of first carrier transport layer 9 and portions of second carrier transport layer 13 which are interdigitated as represented in fig.3A. Thus, lateral dimensions may be extended to large scale manufacturing. Fig.3B represents a sectional view according to the cut line A-A which extends laterally across a central portion of the tandem photovoltaic cell 1 as represented in Fig.3A. However, it has to be noted that Fig.3B represents only a portion of the section A-A comprising two stripes of second carrier transport layer 13 and one stripe of first carrier transport layer 9 but as indicated the pattern of fig.3B is replicated multiple times across the A-A section. It has also to be noted that fig.3B corresponds to fig.1. Fig.3C represents a sectional view according to the cut line B-B which also extends laterally but across a portion of the tandem photovoltaic cell 1 without the perovskite layer 15 and without the capping layer 17.

Fig.3D represents a sectional view according to the cut line C-C which extends laterally across a lateral portion of the tandem photovoltaic cell 1 comprising the metallic contacts 18 as represented in Fig.3A. In this C-C section, the insulator layer 11 covers the first carrier transport layer 9 and the second carrier transport layer 13 is disposed all over the insulator layer 11. The metallic contact 18 also called finger is then disposed over the second carrier transport layer 13.

Actually, the portions of first carrier transport layer 9 and the portions of second carrier transport layer 13 are not exactly interdigitated. Indeed, the portions of the second carrier transport layer 13 (in the shape of parallel stripes as represented in fig.3A for example) are linked to metallic contacts 18 (also called fingers) at both of their extremities whereas there is no connection between the portions (also parallel stripes for example) of the first carrier transport layer 9 at their extremities.

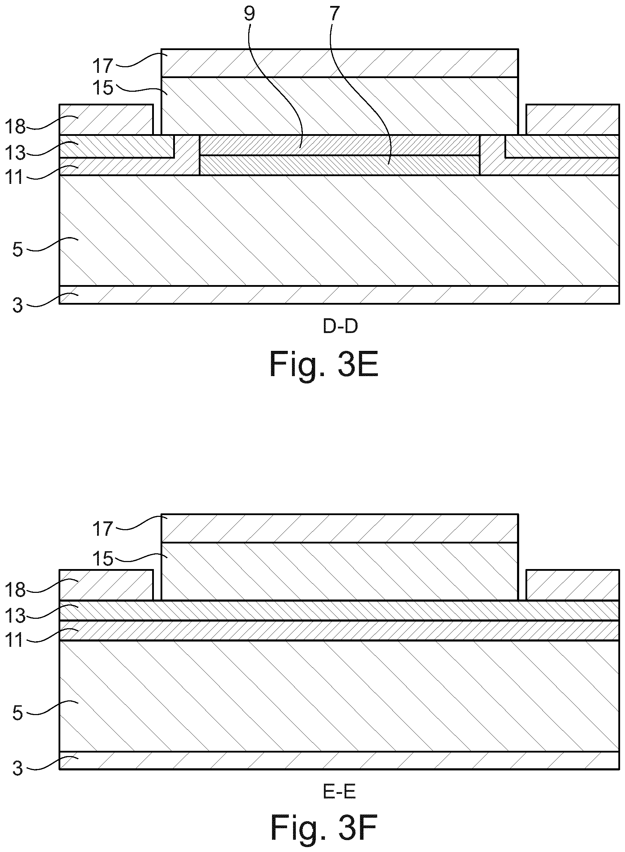

Fig.3E represents a sectional view according to the cutline D-D which extends across a longitudinal portion of the tandem photovoltaic cell 1 along a stripe of first carrier transport layer 9. The stripe of the first carrier transport layer 9 does not extend over the whole length of the tandem photovoltaic cell 1 but only remains in the central part without metallic contact. An insulator layer 11 is disposed at both ends of the stripe of the first carrier transport layer 9. The insulator layer 11 is then covered by a second carrier transport layer 13 and a metallic contact 18 at the longitudinal ends of the tandem photovoltaic cell 1 whereas in the central part, the first carrier transport layer is covered by the perovskite layer 15 and the capping layer 17. A gap is arranged between the perovskite layer 15 and capping layer 17 of the central part a Thus, there is no contact between the stripes of first carrier transport layer 9 and the metallic contacts 18. There is also no contact between the different stripes of first carrier transport layer 9.

Fig.3F represents a sectional view according to the cutline E-E which extends across a longitudinal portion of the tandem photovoltaic cell 1 along a stripe of the second carrier transport layer 13. The stripe of the second carrier transport layer 9 extends over the whole length of the tandem photovoltaic cell 1. The central part of the stripe is covered by a perovskite layer 15 and a capping layer 17 whereas the end parts are covered by the metallic contacts 18. A gap is arranged between the perovskite layer 15 and capping layer 17 of the central part and the metallic contacts 18 of the end parts o the tandem photovoltaic cell 1. The different stripes of second transport carrier layer 13 are therefore connected to each other.

Besides, concerning the second carrier transport layer 13, its free carrier concentration, its thickness and its pitch P are configured to ensure the lateral transport of the free carrier toward the second terminal (which is linked to the metallic contact s 18). The pitch P corresponds to the distance between the ends of a portion of the second carrier transport layer 13 as represented in Fig.3A or more precisely to the distance between the two metallic contacts 18 arranged at both ends of the second carrier transport layer 13 The metallic contacts 18 may be made of Au, Ag, Al, Cu or other metal or alloys..

Thus, the concentration of free carrier in the second carrier transport layer 13 may be increased in order to allow the use of a larger pitch P and a higher thickness of the second carrier transport layer 13. Furthermore, the second carrier layer 13 may comprise one or several sub-layers made of metal or transparent conducting oxide to enhance the lateral conductivity. These sub-layers may sandwich the main layer of the second carrier transport layer 13.

The thickness of the first 9 and second 13 carrier layers as well as the insulator layer 11 are comprised between 2nm and 1µm. The thickness of the perovskite layer 15 is comprised between 100nm and 2µm.

The capping layer 17 may partly embed into the grain boundaries of the perovskite layer 15. The capping layer 17 may be made of any suitable material which may be deposited at a temperature below 110°C and which is stable with respect to the ultra-violet rays. Examples of such materials are, PMMA, Al₂O₃, ...

The thickness of the capping layer 17 may be comprised between 10nm and 200nm.

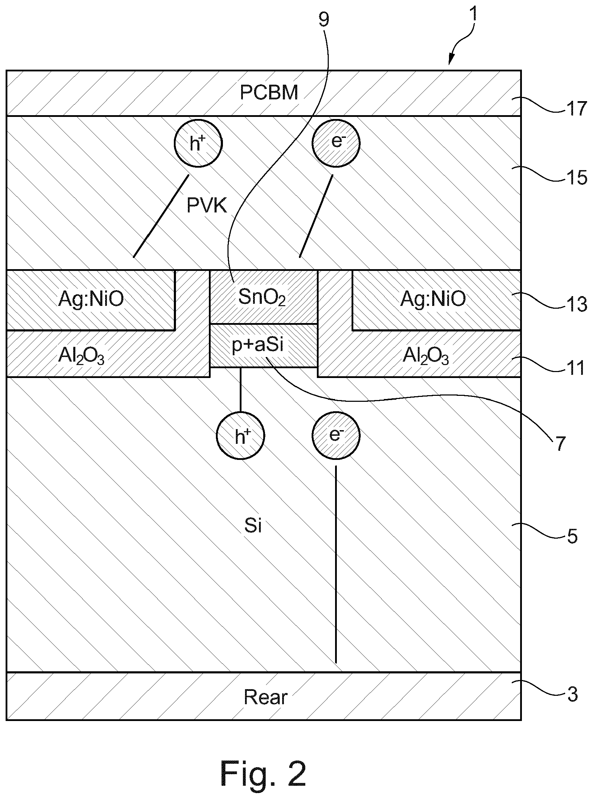

Fig.2 represents an embodiment of the present invention. In this embodiment, the front contact 7 of the silicon bottom cell 2 is made of a P-type doped amorphous silicon "p+aSi" and the first carrier transport layer 9 is made of tin oxide "SnO₂". The first carrier transport layer 9 is a N-type doped layer. As indicated previously, the combination of the front contact 7 made of p-type doped amorphous silicon and the tin oxide layer 9 produces a tunnel junction between the silicon bottom cell 2 and the perovskite top cell 4.

The insulator 11 may be made of an insulating oxide, such as hafnium oxide HfO₂ or aluminum oxide Al₂O₃.

The second carrier transport layer comprises silver doped nickel oxide "AgNiO" and is a P-type doped layer. As indicated previously, the layer of AgNiO may be sandwiched with sub-layers of a metal such as Ni or a transparent conductive oxide "TCO" such as indium tin oxide "ITO" to enhance its lateral conductivity. However, the thickness of a TCO sub-layer needs to remain weak, for example smaller than 100nm in order to limit parasitic absorption in the near infra-red spectrum. The pitch P of the second carrier transport layer 13 is chosen smaller than 5mm, for example smaller than 3mm.

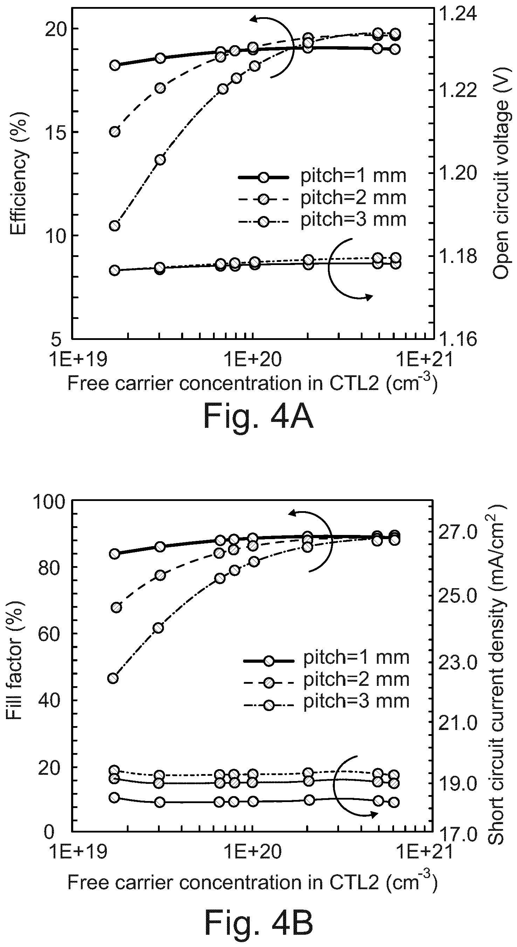

Fig.4A to 4C show different simulations achieved on different configurations of the second carrier transport layer 13 and may be used to determine the different parameters and notably the free carrier concentration according to the desired pitch P. In this simulation a 100nm thick ITO layer with a carrier mobility of 10cm²/Vs is studied as the second carrier transport layer 13 with various free carrier concentration from 1,7E¹⁹ and 6,1E²⁰ cm⁻³. Indeed, Fig.4A represents the simulated efficiency and open circuit voltage of the perovskite top cell in a tandem architecture as a function of the free carrier concentration for different values of pitch P, respectively 1mm, 2mm and 3mm. Fig.4B shows the simulated fill factor and short circuit current density of the perovskite top cell 4 in a tandem architecture as a function of the free carrier concentration for different values of pitch P, respectively 1mm, 2mm and 3mm.

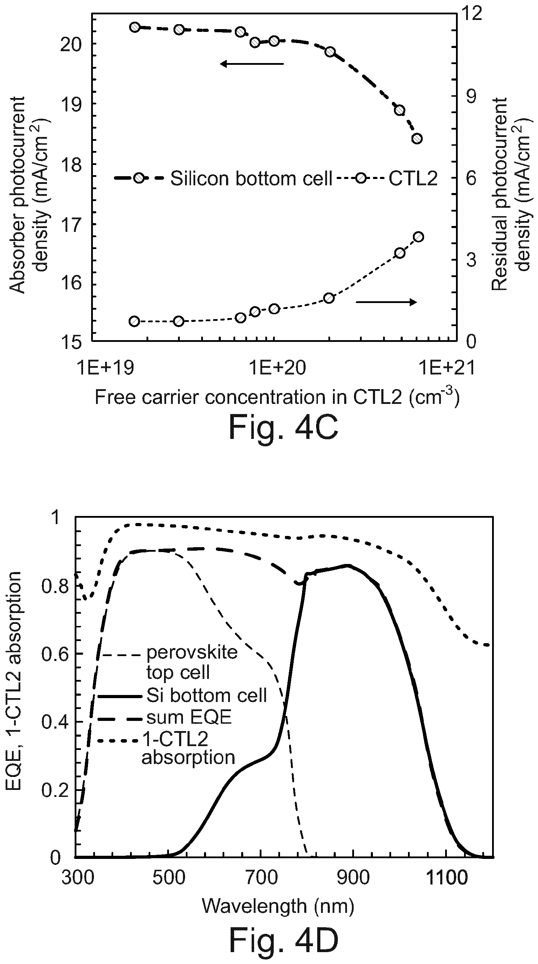

Fig.4C shows the simulated absorber photocurrent density in the silicon bottom cell 2 and the residual photocurrent density in the second carrier transport layer 13 as a function of the free carrier concentration.

One can observe that a concentration of 1E²⁰ cm⁻³ is necessary for pitches P higher than 1mm to obtain an efficiency higher than 18% or a fill factor higher than 80%. The low fill factor arises from the increase of non-radiative recombination in the perovskite layer 15 and the increase of serial resistance in the second carrier transport layer 13.

It also appears that no significant variation is found on the open circuit voltage and the short circuit current density. Significant loss of photocurrent density in the silicon bottom cell is observed when the free carrier concentration in the second carrier transport layer is larger than 1E²⁰ cm⁻³.

Fig.4D represents the simulated external quantum efficiency "EQE" of the perovskite top cell 4 and the silicon bottom cell 2 and the sum of both of them as well as the residual absorption spectrum of the second carrier transport layer 13. Fig.4D shows that the second carrier transport layer 13 of high free carrier concentration mostly introduces photocurrent losses in the infra-red region of the spectrum which results in less photocurrent generated in the silicon bottom cell and therefore to a lower efficiency. Thus, to obtain high efficiency of a perovskite/silicon tandem photovoltaic cell, the free carrier concentration in the second carrier transport layer 13 has to be adjusted to balance the lateral conductivity and the infra-red transparency and therefore to obtain a tandem photovoltaic cell with an improved yield.

The perovskite layer 15 may be an intrinsic layer or a N-doped perovskite layer. The capping layer 17 may be made of Phenyl-C61-Butyric acid Methyl ester "PCBM".

The present invention is not limited to the embodiment represented in Fig.2 which is only a particular example. Two terminal tandem cell comprising other types of material notably for the front contact layer, the first and second carrier transport layers, the insulator layer or the capping layer are also covered by the present invention.

The present invention also refers to an exemplary method for manufacturing a two-terminal "2T" tandem photovoltaic cell comprising a silicon based bottom cell 2 and a perovskite based top cell 4. Other manufacturing methods may be envisaged.

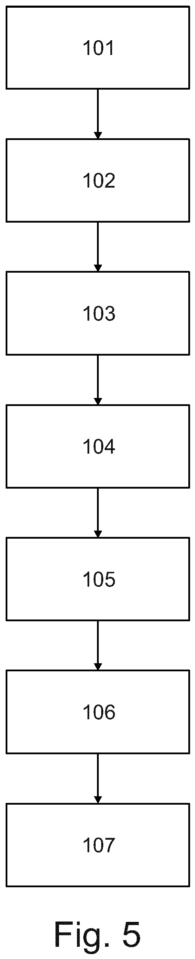

Fig.5 represents the different steps of the manufacturing method.

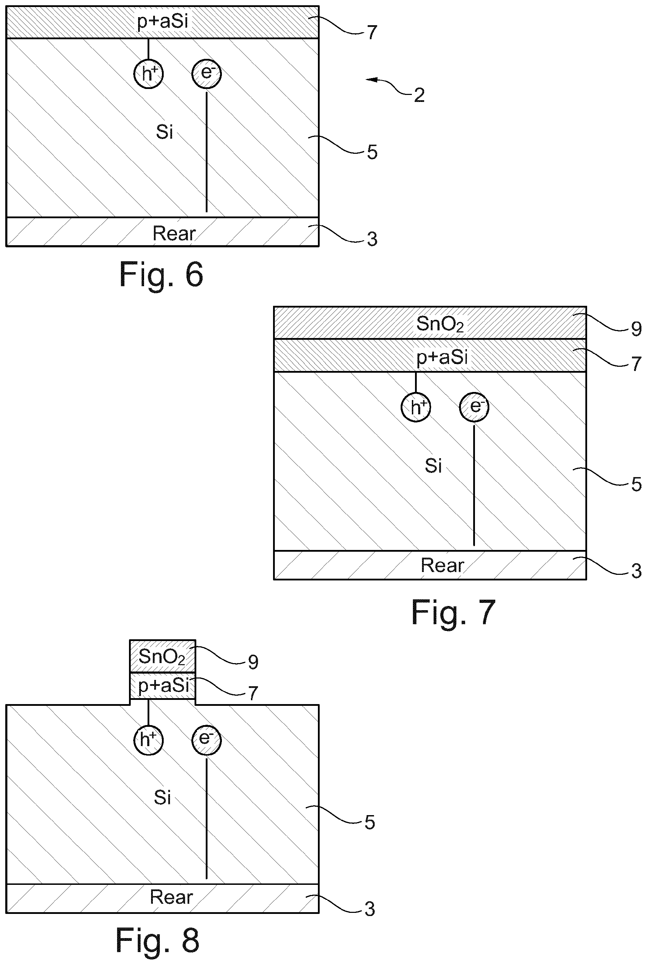

The first step 101 refers to providing a silicon bottom cell 2 corresponding to a first intermediate structure. Such silicon bottom cell 2 may be provided by a manufacturer of the market. Preferably, the silicon bottom cell 2 is provided without anti-reflection layer. As represented in fig.6, the silicon bottom cell 2 comprises a rear contact 3 configured to be linked to a first terminal of the tandem photovoltaic cell, a silicon layer 5 arranged over the rear contact 3 and a front contact 7 arranged over the silicon layer 5.

The second step 102 refers to depositing a first carrier transport layer 9 over the front contact layer 7 as represented in Fig.7 which represents a second intermediate structure. This deposition may be sputter deposition or atomic layer deposition "ALD" or plasma-enhanced chemical vapor deposition "PECVD" or similar physical and chemical vapor phase deposition techniques.

The third step 103 refers to etching selectively the first carrier transport layer 9 and the front contact layer 7 to produce a third intermediate structure represented in Fig.8. In Fig.8, only one stripe of contact layer 7 and first carrier transport layer 9 is represented but in practice several parallel stripes may be achieved. The etching may be a chemical or a physical etching according to a process known from the state of the art.

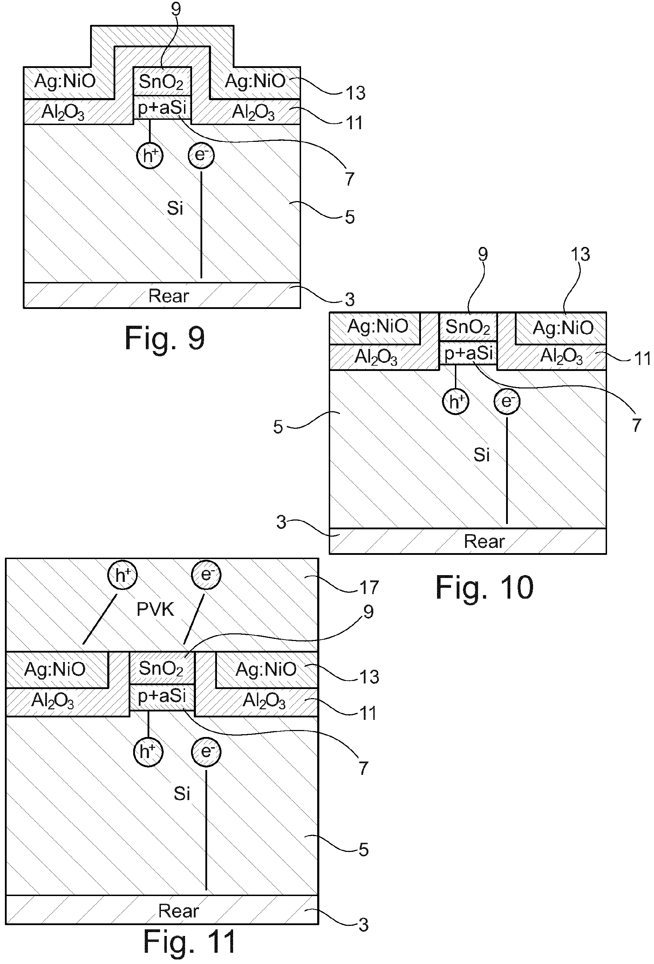

The fourth step 104 refers to depositing an insulator layer 11 and a second carrier transport layer 13 over the third intermediate structure to produce a fourth intermediate structure as represented in Fig.9.

The second carrier transport layer 13 is configured to be linked to a second terminal of the tandem photovoltaic cell 1, for example via metallic contacts 18 arranged at the ends of the stripes of the second carrier transport layer 13. These depositions may be sputter deposition or atomic layer deposition "ALD" or plasma-enhanced chemical vapor deposition "PECVD" or similar physical and chemical vapor phase deposition techniques.

The fifth step 105 refers to etching the fourth intermediate structure to remove the layers covering the first carrier transport layer 9 to produce a fifth intermediate structure as represented in Fig. 10. Such etching enables obtaining a smooth structure with an alternation of stripes of the first 9 and of the second 13 carrier transport layers, two adjacent stripes being separated by an insulator layer 11 to provide a plurality of P-I-N junctions along the lateral axis of the tandem photovoltaic cell. The etching may be a chemical or a physical etching according to a process known from the state of the art.

The sixth step 106 refers to depositing a perovskite layer 15 over the fifth intermediate structure to produce a sixth intermediate structure as represented in Fig. 11. This deposition may be performed via single-step or multi-step state-of-the-art wet solution processing, such as spin-casting, slot-die coating etc, vacuum based processes such as thermal evaporation or hybrid deposition processes combining wet- and vacuum-based procedures.

The seventh step 107 refers to depositing a capping layer 17 over the sixth intermediate structure at a temperature lower than 160°C, in particular lower than 110°C to obtain the stack of layers of the embodiment of the invention presented in Fig.2..

Thus, the present invention discloses a structure of a two-terminal "2T" perovskite/silicon tandem photovoltaic cell enabling reaching a high efficiency due to the combination of the silicon bottom cell 2 and the perovskite top cell 4 while allowing a protection of the perovskite due to the use of a passivation layer or capping layer 17 which is deposited at a temperature below 110°C. The perovskite layer 15 is therefore not damaged during the manufacturing process but is protected from O₂ or H₂O from the environment. Furthermore, the two terminal "2T" structure allows limiting losses. The present invention also refers to the configuration of the second carrier transport layer 13 to obtain a balance between the lateral conductivity and the infra-red transparency leading therefore to an adjustable structure providing enhanced performances.

## Claims

1. Two terminal tandem cell (1) comprising:
- a silicon bottom cell (2) comprising a silicon layer (5), a rear contact (3) configured to be linked to a first terminal and a front contact (7),
- a perovskite top cell (4) comprising a layer of perovskite (15) and a capping layer (17),
wherein the perovskite top cell comprises alternated back contacts made by a first carrier transport layer (9) arranged on the front contact (7) of the silicon bottom cell (2) to produce a recombination layer or a tunnel junction interface and a second carrier transport layer (13) configured to be linked to a second terminal and wherein an insulator layer (11) is arranged on one side between the silicon bottom cell (2) and the second carrier transport layer (13) and on the other side between the first carrier transport layer (9) and the second transport layer (13) and wherein the first carrier transport layer (9) and the second carrier transport layer (13) have opposite doping type.

2. Two terminal tandem cell (1) in accordance with claim 1 wherein the electrical conductivity, the thickness and the pitch (P) of the second carrier transport layer (13) are configured to ensure lateral carrier transport toward the second terminal.

3. Two terminal tandem cell (1) in accordance with one of the previous claims wherein the second carrier transport layer (13) comprises at least one sub-layer made of metal or transparent conducting oxide to enhance lateral carrier transport toward the second terminal.

4. Two terminal tandem cell (1) in accordance with one of the previous claims wherein the thickness of the first carrier transport layer (9), the second carrier transport layer (13) and the insulator layer (11) is comprised between 2nm and 1µm, preferably between 10nm and 100nm.

5. Two terminal tandem cell (1) in accordance with one of the previous claims wherein the thickness of the perovskite layer (15) is comprised between 100nm to 2µm.

6. Two terminal tandem cell (1) in accordance with one of the previous claims wherein the capping layer (17) of the perovskite top cell (4) is deposited at a temperature lower than 160°C.

7. Two terminal tandem cell (1) in accordance with one of the previous claims wherein the capping layer (17) is configured to prevent recombination of free carriers, and is for example made of polymethylmetacrylat "PMMA", Al₂O₃ or SiO₂.

8. Two terminal tandem cell (1) in accordance with one of the previous claims wherein the front contact (7) of the silicon bottom cell (2) is achieved by one of the following solutions:
- a heterojunction of amorphous silicon,
- diffusion doped layers,
- passivating contacts notably polysilicon.

9. Two terminal tandem cell (1) in accordance with one of the previous claims wherein the silicon layer (5) of the silicon bottom cell (2) is made of N-type doped silicon, the front contact (7) of the silicon bottom cell (2) is made of P-type doped silicon and the first carrier transport layer (9) is made of tin oxide "SnO₂".

10. Two terminal tandem cell (1) in accordance with the previous claim wherein the second carrier transport layer (13) comprises a layer of silver doped nickel oxide "Ag:NiO".

11. Two terminal tandem cell (1) in accordance with one of the claims 1 to 8 wherein the silicon layer (5) of the silicon bottom cell (2) is made of P-type doped silicon, the front contact (7) of the silicon bottom cell (2) is made of N-type doped silicon and the first carrier transport layer (9) is made of nickel oxide "NiOₓ".

12. Two terminal tandem cell (1) in accordance with the previous claim wherein the second carrier transport layer (13) comprises a layer of tin oxide "SnO₂".

13. Two terminal tandem cell (1) in accordance with one of the previous claims wherein the second carrier transport layer (13) comprises a free carrier concentration of at least 1E²⁰ and a pitch (P) which is lower than 5mm, for example lower than 3mm.

14. Two terminal tandem cell (1) in accordance with one of the previous claims wherein the insulator layer (11) is made of Hafnium dioxide "HfO_{2"}, or aluminum oxide "Al₂O_{3"}.

15. Method for manufacturing a two terminal tandem cell (1) comprising a silicon bottom cell (2) and a perovskite top cell (4) wherein the method comprises the following steps:
- providing (101) a silicon bottom cell (2) comprising a rear contact (3) configured to be linked to a first terminal and a front contact (7), the silicon bottom cell corresponding to a first intermediate structure,
- depositing (102) a first carrier transport layer (9) having a first doping type over the front contact (7) of the first intermediate structure to produce a second intermediate structure,
- etching (103) selectively the first carrier transport layer (9) and the front contact (7) of the second intermediate structure to produce a third intermediate structure, the first carrier transport layer (9) arranged on the front contact (7) of the silicon bottom cell (2) are configured to produce a recombination layer or a tunnel junction interface,
- depositing (104) an insulator layer (11) and a second carrier transport layer (13) having a second doping type opposite to the first doping type and configured to be linked to a second terminal over the third intermediate structure to produce a fourth intermediate structure, the insulator layer (11) being configured to be located on one side between the first carrier transport layer (9) and the second carrier transport layer (13) and on the other side between the silicon bottom cell and the second carrier transport layer (13),
- etching (105) the fourth intermediate structure to remove the layers covering the first carrier transport layer (9) to produce a fifth intermediate structure,
- depositing (106) a perovskite layer (15) over the fifth intermediate structure to produce a sixth intermediate structure, the first and the second carrier transport layer being configured to form alternated back contact of an obtained perovskite top cell (4)
- depositing (107) a capping layer (17) over the sixth intermediate structure at a temperature lower than 110°C.

16. Manufacturing method in accordance with the previous claim wherein the deposition steps (102, 104 and 107) are made by sputter deposition or an atomic layer deposition "ALD" or plasma-enhanced chemical vapor deposition "PECVD" or physical and chemical vapor phase deposition techniques.

## Patentansprüche

1. Tandemzelle mit zwei Anschlüssen (1), umfassend:
- eine Silicium-Bottomzelle (2), umfassend eine Siliciumschicht (5), einen hinteren Kontakt (3), der zur Verbindung mit einem ersten Anschluss gestaltet ist, und einen vorderen Kontakt (7),
- eine Perovskit-Topzelle (4), umfassend eine Schicht aus Perovskit (15) und eine Deckschicht (17),
wobei die Perovskit-Topzelle abwechselnde hintere Kontakte umfasst, bestehend aus einer ersten Ladungsträgertransportschicht (9), die auf dem vorderen Kontakt (7) der Silicium-Bottomzelle (2) angeordnet ist, um eine Rekombinationsschicht oder eine Tunnelübergangs-Schnittstelle zu bilden, und einer zweiten Ladungsträgertransportschicht (13), gestaltet zur Verbindung mit einem zweiten Anschluss, und wobei eine Isolatorschicht (11) an einer Seite zwischen der Silicium-Bottomzelle (2) und der zweiten Ladungsträgertransportschicht (13) und an der anderen Seite zwischen der ersten Ladungsträgertransportschicht (9) und der zweiten Transportschicht (13) angeordnet ist und wobei die erste Ladungsträgertransportschicht (9) und die zweite Ladungsträgertransportschicht (13) entgegengesetzten Dotierungstyp aufweisen.

2. Tandemzelle mit zwei Anschlüssen (1) gemäß Anspruch 1, wobei die elektrische Leitfähigkeit, die Dicke und das Abstandsmaß (P) der zweiten Ladungsträgertransportschicht (13) dafür gestaltet sind, seitlichen Ladungsträgertransport in Richtung zu dem zweiten Anschluss zu gewährleisten.

3. Tandemzelle mit zwei Anschlüssen (1) gemäß einem der vorstehenden Ansprüche, wobei die zweite Ladungsträgertransportschicht (13) wenigstens eine Teilschicht umfasst, die aus Metall oder transparentem leitfähigem Oxid besteht, um seitlichen Ladungsträgertransport in Richtung zu dem zweiten Anschluss zu verstärken.

4. Tandemzelle mit zwei Anschlüssen (1) gemäß einem der vorstehenden Ansprüche, wobei die Dicke der ersten Ladungsträgertransportschicht (9), der zweiten Ladungsträgertransportschicht (13) und der Isolatorschicht (11) in dem Bereich zwischen 2 nm und 1 µm liegt, vorzugsweise zwischen 10 nm und 100 nm.

5. Tandemzelle mit zwei Anschlüssen (1) gemäß einem der vorstehenden Ansprüche, wobei die Dicke der Perovskitschicht (15) in dem Bereich zwischen 100 nm und 2 µm liegt.

6. Tandemzelle mit zwei Anschlüssen (1) gemäß einem der vorstehenden Ansprüche, wobei die Deckschicht (17) der Perovskit-Topzelle (4) bei einer Temperatur von unter 160 °C abgeschieden ist.

7. Tandemzelle mit zwei Anschlüssen (1) gemäß einem der vorstehenden Ansprüche, wobei die Deckschicht (17) dafür gestaltet ist, Rekombination von freien Ladungsträgern zu verhindern, und beispielsweise aus Polymethylmethacrylat "PMMA", Al₂O₃ oder SiO₂ besteht.

8. Tandemzelle mit zwei Anschlüssen (1) gemäß einem der vorstehenden Ansprüche, wobei der vordere Kontakt (7) der Silicium-Bottomzelle (2) durch eine der folgenden Lösungen ausgeführt ist:
- ein Heteroübergang von amorphem Silicium,
- diffusionsdotierte Schichten,
- passivierende Kontakte, insbesondere Polysilicium.

9. Tandemzelle mit zwei Anschlüssen (1) gemäß einem der vorstehenden Ansprüche, wobei die Siliciumschicht (5) der Silicium-Bottomzelle (2) aus N-Typ-dotiertem Silicium besteht, der vordere Kontakt (7) der Silicium-Bottomzelle (2) aus P-Typ-dotiertem Silicium besteht und die erste Ladungsträgertransportschicht (9) aus Zinnoxid "SnO₂" besteht.

10. Tandemzelle mit zwei Anschlüssen (1) gemäß dem vorstehenden Anspruch, wobei die zweite Ladungsträgertransportschicht (13) eine Schicht aus silberdotiertem Nickeloxid "Ag:NiO" umfasst.

11. Tandemzelle mit zwei Anschlüssen (1) gemäß einem der Ansprüche 1 bis 8, wobei die Siliciumschicht (5) der Silicium-Bottomzelle (2) aus P-Typ-dotiertem Silicium besteht, der vordere Kontakt (7) der Silicium-Bottomzelle (2) aus N-Typ-dotiertem Silicium besteht und die erste Ladungsträgertransportschicht (9) aus Nickeloxid "NiOₓ" besteht.

12. Tandemzelle mit zwei Anschlüssen (1) gemäß dem vorstehenden Anspruch, wobei die zweite Ladungsträgertransportschicht (13) eine Schicht aus Zinnoxid "SnO₂" umfasst.

13. Tandemzelle mit zwei Anschlüssen (1) gemäß einem der vorstehenden Ansprüche, wobei die zweite Ladungsträgertransportschicht (13) eine Konzentration an freien Ladungsträgern von wenigstens 1E²⁰ und ein Abstandsmaß (P), das kleiner als 5 mm, beispielsweise kleiner als 3 mm, aufweist.

14. Tandemzelle mit zwei Anschlüssen (1) gemäß einem der vorstehenden Ansprüche, wobei die Isolatorschicht (11) aus Hafniumdioxid "HfO₂" oder Aluminiumoxid "Al₂O₃" besteht.

15. Verfahren zur Herstellung einer Tandemzelle mit zwei Anschlüssen (1) umfassend eine Silicium-Bottomzelle (2) und eine Perovskit-Topzelle (4), wobei das Verfahren die folgenden Schritte umfasst:
- Bereitstellen (101) einer Silicium-Bottomzelle (2) umfassend einen hinteren Kontakt (3), der zur Verbindung mit einem ersten Anschluss gestaltet ist, und einen vorderen Kontakt (7), wobei die Silicium-Bottomzelle einer ersten Zwischenstruktur entspricht,
- Abscheiden (102) einer ersten Ladungsträgertransportschicht (9) mit einem ersten Dotierungstyp über den vorderen Kontakt (7) der ersten Zwischenstruktur, um eine zweite Zwischenstruktur zu bilden,
- selektives Ätzen (103) der ersten Ladungsträgertransportschicht (9) und des vorderen Kontakts (7) der zweiten Zwischenstruktur, um eine dritte Zwischenstruktur zu bilden, wobei die erste Ladungsträgertransportschicht (9), die auf dem vorderen Kontakt (7) der Silicium-Bottomzelle (2) angeordnet ist, dafür gestaltet ist, eine Rekombinationsschicht oder eine Tunnelübergangs-Schnittstelle zu bilden,
- Abscheiden (104) einer Isolatorschicht (11) und einer zweiten Ladungsträgertransportschicht (13) mit einem zweiten Dotierungstyp, der dem ersten Dotierungstyp entgegengesetzt ist, und gestaltet zur Verbindung mit einem zweiten Anschluss, über der dritten Zwischenstruktur, um eine vierte Zwischenstruktur zu bilden, wobei die Isolatorschicht (11) dafür gestaltet ist, an einer Seite zwischen der ersten Ladungsträgertransportschicht (9) und der zweiten Transportschicht (13) und an der anderen Seite zwischen der Silicium-Bottomzelle und der zweiten Transportschicht (13) angeordnet zu sein,
- Ätzen (105) der vierten Zwischenstruktur, um die Schichten zu entfernen, die die erste Ladungsträgertransportschicht (9) bedecken, um eine fünfte Zwischenstruktur zu bilden,
- Abscheiden (106) einer Perovskitschicht (15) über der fünften Zwischenstruktur, um eine sechste Zwischenstruktur zu bilden, wobei die erste und die zweite Ladungsträgertransportschicht dafür gestaltet sind, abwechselnde hintere Kontakte einer erhaltenen Perovskit-Topzelle (4) zu bilden,
- Abscheiden (107) einer Deckschicht (17) über der sechsten Zwischenstruktur bei einer Temperatur von unter 110 °C.

16. Herstellungsverfahren gemäß dem vorstehenden Anspruch, wobei die Abscheidungsschritte (102, 104 und 107) durch Sputterabscheidung oder eine Atomlagenabscheidung "ALD" oder plasmaverstärkte chemische Gasphasenabscheidung "PECVD" oder physikalische und chemische Gasphasenabscheidungsverfahren durchgeführt werden.

## Revendications

1. Cellule tandem à deux terminaux (1) comprenant :
- une cellule inférieure de silicium (2) comprenant une couche de silicium (5), un contact arrière (3) configuré pour être relié à un premier terminal et un contact avant (7),
- une cellule supérieure de pérovskite (4) comprenant une couche de pérovskite (15) et une couche de recouvrement (17),
la cellule supérieure de pérovskite comprenant des contacts arrière alternés réalisés par une première couche de transport de porteurs (9) agencée sur le contact avant (7) de la cellule inférieure de silicium (2) pour produire une couche de recombinaison ou une interface de jonction tunnel et une seconde couche de transport de porteurs (13) configurée pour être reliée à un second terminal, et dans laquelle une couche d'isolant (11) est agencée d'un côté entre la cellule inférieure de silicium (2) et la seconde couche de transport de porteurs (13) et de l'autre côté entre la première couche de transport de porteurs (9) et la seconde couche de transport (13), et dans laquelle la première couche de transport de porteurs (9) et la seconde couche de transport de porteurs (13) ont un type de dopage opposé.

2. Cellule tandem à deux terminaux (1) selon la revendication 1, dans laquelle la conductivité électrique, l'épaisseur et le pas (P) de la seconde couche de transport de porteurs (13) sont configurés pour assurer le transport de porteurs latéral vers le second terminal.

3. Cellule tandem à deux terminaux (1) selon l'une quelconque des revendications précédentes, dans laquelle la seconde couche de transport de porteurs (13) comprend au moins une sous-couche en métal ou en oxyde conducteur transparent pour améliorer le transport de porteurs latéral vers le second terminal.

4. Cellule tandem à deux terminaux (1) selon l'une quelconque des revendications précédentes, dans laquelle l'épaisseur de la première couche de transport de porteurs (9), de la seconde couche de transport de porteurs (13) et de la couche d'isolant (11) est comprise entre 2 nm et 1 um, de préférence entre 10 nm et 100 nm.

5. Cellule tandem à deux terminaux (1) selon l'une quelconque des revendications précédentes, dans laquelle l'épaisseur de la couche de pérovskite (15) est comprise entre 100 nm et 2 um.

6. Cellule tandem à deux terminaux (1) selon l'une quelconque des revendications précédentes, dans laquelle la couche de recouvrement (17) de la cellule supérieure de pérovskite (4) est déposée à une température inférieure à 160 °C.

7. Cellule tandem à deux terminaux (1) selon l'une quelconque des revendications précédentes, dans laquelle la couche de recouvrement (17) est configurée pour empêcher la recombinaison des porteurs libres et est par exemple constituée de polyméthylmétacrylate « PMMA », d'Al₂O₃ ou de SiO₂.

8. Cellule tandem à deux temrinaux (1) selon l'une quelconque des revendications précédentes, dans laquelle le contact avant (7) de la cellule inférieure de silicium (2) est réalisé par l'une des solutions suivantes :
- une hétérojonction de silicium amorphe,
- des couches dopées par diffusion,
- des contacts de passivation notamment en polysilicium.

9. Cellule tandem à deux terminaux (1) selon l'une quelconque des revendications précédentes, dans laquelle la couche de silicium (5) de la cellule inférieure de silicium (2) est en silicium dopé de type N, le contact avant (7) de la cellule inférieure de silicium (2) est en silicium dopé de type P et la première couche de transport de porteurs (9) est en oxyde d'étain « SnO₂ ».

10. Cellule tandem à deux terminaux (1) selon la revendication précédente, dans laquelle la seconde couche de transport de porteurs (13) comprend une couche d'oxyde de nickel dopé à l'argent « Ag:NiO ».

11. Cellule tandem à deux terminaux (1) selon l'une quelconque des revendications 1 à 8, dans laquelle la couche de silicium (5) de la cellule inférieure de silicium (2) est en silicium dopé de type P, le contact avant (7) de la cellule inférieure de silicium (2) est en silicium dopé de type N et la première couche de transport de porteurs (9) étant en oxyde de nickel « NiOₓ ».

12. Cellule tandem à deux terminaux (1) selon la revendication précédente, dans laquelle la seconde couche de transport de porteurs (13) comprend une couche d'oxyde d'étain « SnO₂ ».

13. Cellule tandem à deux terminaux (1) selon l'une quelconque des revendications précédentes, dans laquelle la seconde couche de transport de porteurs (13) comprend une concentration de porteurs libres d'au moins 1E²⁰ et un pas (P) inférieur à 5 mm, par exemple inférieur à 3 mm.

14. Cellule tandem à deux terminaux (1) selon l'une quelconque des revendications précédentes, dans laquelle la couche isolante (11) est en dioxyde de hafnium « HfO₂ » ou oxyde d'aluminium « Al₂O₃ ».

15. Procédé de fabrication d'une cellule tandem à deux terminaux (1) comprenant une cellule inférieure de silicium (2) et une cellule supérieure de pérovskite (4), le procédé comprenant les étapes suivantes :
- la fourniture (101) d'une cellule inférieure de silicium (2) comprenant un contact arrière (3) configuré pour être relié à un premier terminal et un contact avant (7), la cellule inférieure de silicium correspondant à une première structure intermédiaire,
- le dépôt (102) d'une première couche de transport de porteurs (9) ayant un premier type de dopage sur le contact avant (7) de la première structure intermédiaire pour produire une deuxième structure intermédiaire,
- la gravure (103) sélectivement de la première couche de transport de porteurs (9) et du contact avant (7) de la deuxième structure intermédiaire pour produire une troisième structure intermédiaire, la première couche de transport de porteurs (9) agencée sur le contact avant (7) de la cellule inférieure de silicium (2) est configurée pour produire une couche de recombinaison ou une interface de jonction tunnel,
- le dépôt (104) d'une couche d'isolant (11) et d'une seconde couche de transport de porteurs (13) ayant un second type de dopage opposé au premier type de dopage et configurée pour être reliée à un deuxième terminal sur la troisième structure intermédiaire pour produire une quatrième structure intermédiaire, la couche d'isolant (11) étant configurée pour être située d'un côté entre la première couche de transport de porteurs (9) et la seconde couche de transport de porteurs (13) et de l'autre côté entre la cellule inférieure de silicium et la seconde couche de transport de porteurs (13),
- la gravure (105) de la quatrième structure intermédiaire pour enlever les couches recouvrant la première couche de transport de porteurs (9) afin de produire une cinquième structure intermédiaire,
- le dépôt (106) d'une couche de pérovskite (15) sur la cinquième structure intermédiaire pour produire une sixième structure intermédiaire, la première et la seconde couche de transport de porteurs étant configurées pour former un contact arrière alterné d'une cellule supérieure de pérovskite obtenue (4)
- le dépôt (107) d'une couche de recouvrement (17) sur la sixième structure intermédiaire à une température inférieure à 110 °C.

16. Procédé de fabrication selon la revendication précédente dans lequel les étapes de dépôt (102, 104 et 107) sont réalisées par dépôt par pulvérisation cathodique ou par un dépôt par couche atomique « ALD » ou par un dépôt chimique en phase vapeur assisté par plasma « PECVD » ou par des techniques de dépôt physique et chimique en phase vapeur.
